(19) Europäisches Patentamt

European Patent Office

Office européen des brevets

(11) EP 1 037 059 A1

(12) **EUROPEAN PATENT APPLICATION**

(43) Date of publication:
20.09.2000 Bulletin 2000/38

(51) Int. Cl.7: **G01R 23/16**

(21) Application number: **99400535.3**

(22) Date of filing: **05.03.1999**

(84) Designated Contracting States:
**AT BE CH CY DE DK ES FI FR GB GR IE IT LI LU MC NL PT SE**
Designated Extension States:
**AL LT LV MK RO SI**

(71) Applicant: **Advantest Corporation**
**Nerima-ku, Tokyo 179-0071 (JP)**

(72) Inventors:
• **Griffault, Jacky**
**91190 Gif sur Yvette (FR)**

• **Richard, Guy**
**91300 Massy (FR)**
• **Adrien, Laurent**
**91580 Etrechy (FR)**
• **Faure, Eric**
**91470 Forges les Bains (FR)**
• **Zimniak, Samuel**
**91120 Palaiseau (FR)**

(74) Representative: **Uchida, Kenji**
**Cabinet Fedit-Loriot**
**38,avenue Hoche**
**75008 Paris (FR)**

(54) **Frequency converter for spectrum analysers**

(57) The invention relates to a frequency up and down converting device for a spectrum analyser.

The device of the invention comprises first mixing means (2) for mixing a received signal, in a wide range of frequencies, with the output of first oscillating means (1), intermediate frequency filtering means (3) and second mixing means (5) for mixing the filtered signal with the output of second oscillating means (6), the filtering means and the second oscillating means are without resonant cavities. This reduces the form factor the weight and the cost of the device.

The intermediate frequency filtering means comprise cascaded etched resonator forming a filter with a low quality factor and a high insertion loss. These may however be compensated by the amplifier.

Figure 1

**Description**

Field of the Invention

The present invention relates to a device for converting frequencies. It also relates to a spectrum analyser comprising such a device.

Background of the Invention

A spectrum analyser is a measuring instrument, which quantifies the energy, or the electromagnetic power contained in each frequency of the electromagnetic spectrum of a signal to be analysed. Such analysers typically operate in a frequency range from a few hundreds hertz or less to a few gigahertz. This instrument is particularly useful for measuring the electromagnetic perturbations, which disturb wireless transmissions. It is also used for verifying and tuning communication systems installed on high point like specialised towers, high buildings and the like. For these reasons and because wireless transmission is a fast growing business, weight and volume become more and more important for security and working conditions of users.

To determine power at each frequency, between a minimum frequency $f_{min}$ and a maximum frequency $f_{max}$, it is usual to sweep operating spectrum with a band pass filter and to measure the power at the output of the filter. The bandwidth of the filter is variable, the minimum value and the maximum depending on the general performance of the final instrument. For a medium class, the filter is variable from 1 kHz to 3 MHz with steps 1, 3, 10, 33. As no technology is available to make this filtering directly in the entire frequency range, the signal to be analysed is usually converted to a given frequency, by heterodyning, and is filtered accordingly.

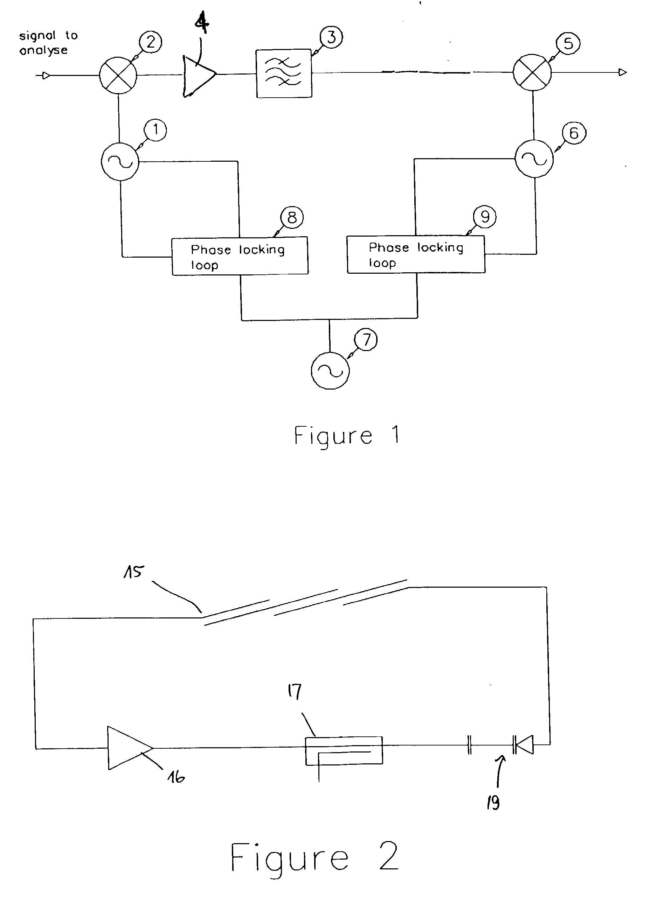

Figure 1 shows an example of a prior art device, used in the front end of commercially available spectrum analyser like the ones sold by the applicant. It outlines the different problems to be solved according to the invention, using a simple numerical example. The device of figure 1 comprises a first mixer 2, that receives the signal to be analysed at a frequency $f_{in}$ and the output of a first local oscillator 1 at a frequency $f_{ol1}$. It should be understood that the first mixer does not receive a signal at a single frequency - even if "$f_{in}$" is used for the purpose of convenience. The output of the first mixer at the frequency $f_m$ is inputted to a first intermediate frequency amplifier 4; the output of the amplifier is filtered by a first intermediate frequency filter 3, filtering around a frequency $f_i$; the output of the filter 3 is mixed in a second mixer 5 with the output of a second local oscillator 6. The signal provided by the second mixer - later referenced as signal at the second intermediate frequency, second IF or $f_{out}$ - is used for the analysis, and is further heterodyned to be brought to lower frequencies. The first and second local oscillators are connected to first and second phase locking loops 8, 9 respectively. The phase locking loops are connected to a reference oscillator 7.

The operation of the device of figure 1 is the following. The first local oscillator 1 and the first mixer 2 convert the signal received by the converting device into a signal around an intermediate frequency $f_i$ (first IF) higher than the highest frequency to analyse. At this frequency, the first IF filter 3 eliminate most of the spurious frequencies created by the mixing in the first mixer. The first mixer provides frequencies lower and higher than the frequency of the first local oscillator. The range of frequency used here is the one lower than the frequency of the first local oscillator; thus, $f_m = f_{ol1} - f_{in}$, the frequency $f_m$ provided by the first mixer equals the frequency $f_{ol1}$ of the first LO minus the frequency $f_{in}$ of the analysed signal.

The first LO is swept in frequency from the $f_{min} + f_i$ to $f_{max} + f_i$, that is from the lowest frequency to be analysed plus the first IF up to the highest frequency plus the first IF; typically, these frequencies range from a frequency some kHz above the first IF to a frequency 3 GHz above the first IF. Like this, the first mixer provides at a fixed output frequency and at a given time a signal representative of the power contained at each frequency of the sweeped spectrum. The correlation between power and frequency may be derived from the frequency of the first LO at any time. To improve the accuracy, the first LO can be phase locked to a reference oscillator 7 by a sampling system 8.

Usually, the first IF is too high to be used for the variable resolution filtering, so that it is converted down to several megahertz, at a frequency easier to use and where high Q quartz filters can be used, or even at lower frequencies. Unfortunately, each mixing step creates many spurious signals, which can disturb the measure; one may cite among those spurious signals the image frequencies and the leakage from the oscillators, as exemplified below. As it is not always possible to filter these spurious signals because they are too close, the best way to avoid them is to convert the signal of the first IF by several cascaded mixers and local oscillators, using a so called super heterodyning process. The first stage of the super heterodyning circuit is represented on figure 1.

A second mixer 5 and a second local oscillator (second LO) 6 are first used to convert the signal to several hundreds of megahertz. To obtain a good phase noise for the instrument, the first LO and the second LO preferably have a good phase noise close to the carrier. Usually the second LO is designed with a high quality factor resonator, and comprises a dielectric resonator which need a metallic cavity. The accuracy of the oscillation frequency is improved by a phase locking to the reference oscillator 7 of the instrument. One may use an external oscillator for the reference oscillator 7.

The following values exemplify the operation of the device of Fig. 1, for a first intermediate frequency

$f_i$ = 4,0614 GHz and for a fixed output frequency $f_{out}$ of 221,4 MHz; for a frequency $f_{in}$ to be analysed of 1 GHz, the frequencies of the local oscillators are the following:

$f_{ol1}$ = 5,0614 GHz, for the first local oscillator;
$f_{ol2}$ = 3,840 GHz, for the second local oscillator.

For those frequencies, the device of figure 1 outputs a signal at a frequency $f_{out}$ of 221,4 MHz

In this case, the intermediate frequency filter will receive the following frequencies:

$$f_{ol1} - f_{in} = 4,0164 \text{ GHz};$$

$$f_{ol1} + f_{in} = 6,0164 \text{ GHz}$$

The first of these frequencies is representative of the peak at $f_{in}$ in the signal to be analysed and will thereafter be apparent in the output signal. The second of these frequencies is above the band of the first intermediate frequency filter and will be cancelled after filtering by the first intermediate frequency filter.

In this case, the image frequency $f'_{in}$ = 9,1228 GHz will also cause the following frequencies after mixing with the first local oscillator:

$$f'_{in} - f_{ol1} = 4,0164 \text{ GHz};$$

$$f_{ol1} + f'_{in} = 14,1392 \text{ GHz}$$

The second of these frequencies is above the band of the intermediate frequency filter and will be cancelled after filtering by the first intermediate frequency filter. However, the first frequency $f'_{in} - f_{ol1}$ will create an image peak in the output signal, and should be cancelled; otherwise, the analyser will produce an output at 1 GHz - even if there is no signal at 1 GHz but simply a signal at 9,1228 GHz. To ensure that this is the case, the device of figure 1 may be provided with an input low pass filter, that will cancel any signal at the image frequency $f'_{in}$.

The filtered signal output by the first intermediate filter is mixed with the second local frequency. The filtered signal at the frequency $f_{ol1} - f_{in}$ = 4,0164 GHz will be transformed in the following frequencies after mixing with the second local oscillator:

$$(f_{ol1} - f_{in}) - f_{ol2} = 221,4 \text{ MHz};$$

$$(f_{ol1} - f_{in}) + f_{ol2} = 7,8564 \text{ GHz}$$

The first of these two frequencies is representative of the peak at $f_{in}$ = 1 GHz in the signal to be analysed. The second one is far above the band of the analysing device and may be ignored.

Signal leaking from the second oscillator through the second mixer, at frequency $f_{ol2}$ and its harmonics, will also propagate towards the first local oscillator and may be combined with the signal originating from the first local oscillator, thus creating more spurious signals. The first intermediate frequency filter should preferably limit as much as possible these effects.

Similarly, there exists an image frequency $f''_{in}$ for the second mixing stage. In the example where $f_{in}$ = 1 GHz, $f''_{in}$ = 3,6186 GHz, so that

$$f_{ol2} - f''_{in} = 221,4 \text{ GHz}.$$

Thus, in the second mixing step, this second image frequency also creates one dummy peak in the signal to be analysed. The intermediate filter should also preferably be able to cancel the signal at this intermediate frequency.

Proceeding further with the analysis of the possible frequencies in the device of figure 1, one realises that the second harmonic of a signal at the frequency

$$f_i - f_{out}/2 = 3,9057 \text{ GHz}$$

when combined with the second harmonic of the local oscillator at the frequency $2.f_{ol2}$ = 7,680 GHz, will also generate a peak at a frequency $f_{out}$ at the output of the device of figure 1.

The intermediate frequency filter should therefore preferably cancel the image signal at the frequency $f''_{in}$ or at the frequency $f_i \pm f_{out}/2$, and should preferably avoid any leak from the second local oscillator to the first local oscillator.

The prior art solution for the intermediate frequency filter is comprised of a filter with resonant cavities. For instance, one could use a metallic cavities filter, or of a dielectric resonator filter, so as to obtain the necessary narrow bandwidth, and the steep sides necessary to ensure an appropriate rejection of the local oscillators and of the image frequencies. A filter of the dielectric resonator type needs in addition a metallic cavity and a tuning system to adjust its resonance frequency. As an example, a usual metallic cavity filter of the type used for the intermediary frequency filter in the device of figure 1 could have a high quality ratio of less than 0.5%, e.g. a band of 20 MHz for an overall operating range of more than 4 GHz.

This kind of filter comprises a cavity, whose size or dimensional features are used for filtering the signal. This cavity may be a simple metallic cavity; alternatively, the cavity may contain a dielectric resonator. In both cases, changes to at least one dimensional features of the cavity are carried out to finely tune the frequency of the filter. The size or dimensional features of the cavity will in each case be directly related to the processing of the signal.

One problem of these resonant cavities is that they are rather big and costly, due to the cost of the machining, or cost of the dielectric resonators and of the tuning elements; in addition, they limit any reduction of the size and weight of the converting device.

However, due to the required quality of the intermediate frequency filter for a device similar to the one of figure 1, there exists a technical prejudice against the use of filters that do not comprise a resonant cavity. For the person skilled in the art of microwave devices, such resonant cavity filters are the only filters that provide the necessary quality of the intermediate frequency filters.

Furthermore, as explained above, the second local oscillator of the frequency converting device should have a very low phase noise; again, there is a prejudice against the use of an oscillator that do not comprise a resonant cavity. For the person skilled in the art of microwaves, resonant cavities are the only realistic solution to ensure such a low phase noise.

Summary of the Invention

The invention proposes to use a solution to the problem of size and weight of the frequency converting devices of the type described in reference to figure 1. It overcomes the technical prejudice against the use for such an IF filter of microwaves filters that do not comprise a metallic cavity. It also overcomes the prejudice against the use of a second oscillator without any resonant cavity.

The invention thus allows a reduction of the size and weight of the frequency converting device; it also permits lower manufacturing costs.

The invention actually proposes a frequency converting device, comprising first mixing means for mixing a received signal, in a range of frequencies from several hundreds of hertz to several gigahertz, with the output of first oscillating means, amplifying means for amplifying the mixed signal, intermediate frequency filtering means for filtering the amplified signal around an intermediate frequency, and second mixing means for mixing the filtered signal with the output of second oscillating means, wherein the filtering means and the second oscillating means are without resonant cavities.

In a preferred embodiment of the invention, the filtering means and the second oscillating means are components formed in a substrate, the major part of the energy propagating through the substrate.

The second oscillating means may comprise a feedback oscillator using an etched coupled lines filter as a resonant element.

In this case, the second oscillating means may further comprise a varactor diode for inputting into the second oscillating means the error signal between the second oscillating means and a reference clock.

Preferably, the second oscillating means are locked to a reference clock by using a wide band phase locking with a sampling system.

In another embodiment of the invention, the intermediate frequency filtering means comprise at least an etched resonator.

In this case, the device may comprise a plurality of cascaded etched resonators.

Preferably, a resonator comprises two current paths, each path acting simultaneously as means for matching the resonant frequency of the resonator.

In this case, each path may comprise a coupling gap defined between coupling lines.

Each resonator may have the shape of a rectangle cut in the middle of two opposite sides. In this case, the two halves of each opposite side may each have at their end a coupling line.

Preferably, the input and output of the resonator are located at opposite corners of the resonator.

In another embodiment of the invention, the first oscillating means have a variable frequency in the range from 3 to 8 GHz.

The invention also provides a spectrum analyser with such a device.

Brief Description of the Invention

Further features and advantages of the invention will appear from the following description of embodiments of the invention, given as non-limiting example, with reference to the accompanying drawings, in which:

- figure 1 is a schematic diagram of a prior art frequency convening device;
- figure 2 is a schematic diagram of a second oscillator according to the invention;
- figure 3 is a schematic diagram of a phase locking loop for the oscillator of figure 2;
- figure 4 is a schematic diagram of an intermediate frequency filter according to the invention;
- figure 5 is an enlarged view of one resonator of the filter of figure 4;
- figures 6 and 7 are "gedanken" experiments explaining the operation of one resonator.

Best Mode of Carrying out the Invention

The invention proposes a solution that avoids using resonant metallic cavities in a frequency converting device of the type described in reference to figure 1. In the following description, the words "resonant cavities" should be understood, as explained above, as cavities the size or dimensional features of which will in each case be directly related to the processing of the signal. These resonant cavities typically comprise metallic cavities, and metallic cavities provided with a dielectric resonator.

On the contrary, the words "without metallic cavities" cover the rest of the microwave devices, and particularly those devices in which the energy or the major part of the energy is propagated in the substrate; that is, the lines of the electrical field are concentrated in the substrate. These devices may be comprised in a metallic cavity forming a casing; however, the size and dimensions of such metallic cavities have no influence on the processing of the signal, and may be varied according to mechanical constraints, without having to take into account electrical constraints. Such devices "without metallic cavities" may comprise microstripped lines, coplanar lines, or strip lines or so-called sandwich lines, or any combinations of these.

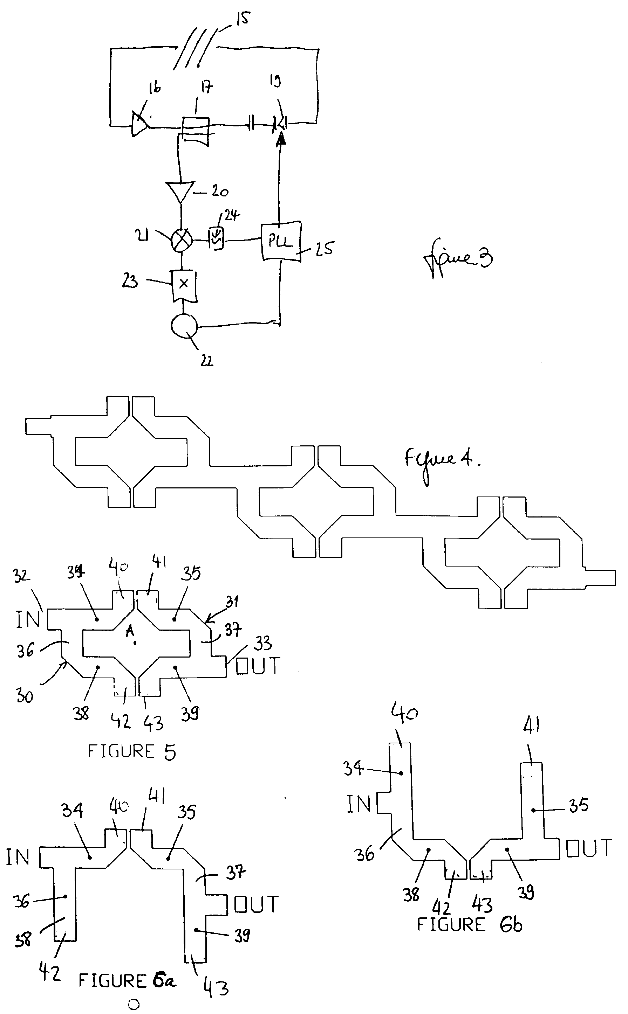

Figure 2 is a schematic diagram of a second oscillator according to the invention; this oscillator can be used in a device of the type depicted in figure 1; it is preferably used in combination with the filter of figure 4. The oscillator of figure 2 is a feedback oscillator with an etched coupled lines filter as resonant element. It comprises, in series in a loop, a coupled lines filter 15, an amplifier 16, the input of which is connected to one side of the coupled lines filter, a coupler 17 connected to the output of the amplifier 16, and a varactor diode 19 connected between the coupler and the coupled lines filter.

The operation of the oscillator of figure 2 is the following: the oscillator is a feedback oscillator, using the coupled lines filter as a resonant element. The amplifier 2 is a low cost wide band monolithic amplifier. The coupler allows the coupling out of the local oscillator signal at the second frequency, this signal is provided to the second mixer and to the phase locking device of figure 3; the varactor diode inserted in series is controlled by the error signal between the second frequency and the reference frequency, as detailed below. It enables an oscillation variation big enough to phase lock the oscillator on the reference oscillator. The total length of the circuit is computed in order to have exactly a multiple of 360 degree at the oscillation frequency, in the loop made by the circuit.

If a low cost microwave substrate, having large manufacturing tolerance is used, then a tuning of the center frequency can be necessary. This tuning can be made by applying on the resonator a variable surface of a microwave material, for example a piece of substrate, glued or screwed at the good position. This tuning of the resonance frequency may be carried out at the manufacturing of the device, and does not involve any further tuning like the prior art device of figure 1.

The oscillator of figure 2 is exemplified in a micro-stripped line embodiment. It may easily be realised in a coupled lined or strip line substrate.

The phase noise of the oscillator of figure 2 is not as good as with a dielectric resonator oscillator; however, according to the invention, the phase noise performances are maintained, near the carrier, by using a wide band phase locking loop for locking the oscillator to the reference oscillator. This ensures that the phase noise degradation will only occur far from the central frequency of the phase locking system. This ensures that although the phase noise of the oscillator of figure 2 is not as good as the one of a prior art oscillator with a metallic cavity, it does not prejudice the operation of the frequency converting device.

Figure 3 shows a view of the oscillator of figure 2 together with a possible phase locking circuit. The phase locking circuit of figure 3 is a wide band phase locking with a sampling system. The use of a sub-sampling system, that is the use of a multiplier and a mixer for multiplying the reference clock and mixing it with the signal from the second oscillator provides better accuracy than a usual division of the signal from the second oscillator.

As shown on figure 3, the signal coupled out of the second local oscillator by the coupler is amplified in an amplifier 20, and is mixed in a mixer 21 with a signal coming from a reference clock 22 and a multiplier 23. The mixed signal is filtered in a low pass filter 24; the error signal outputted by the filter 24 is provided to a phase locking loop integrated circuit 25, that also receives the signal from the reference clock 22; the phase locked error signal is provided to the varactor diode to be inputted into the second local oscillator.

The operation of the circuit of figure 3 is explained, using the frequency of 3840 MHz exemplified above; the reference clock provides a 200 MHz signal; this signal may be derived from a usual 10 MHz clock. The multiplier 23 is a high quality multiplier using a step recovery diode (SRD) and provides, inter alia a signal at a frequency of 3800 MHz. The mixer 21 thus provides, among other signals, a signal at a frequency of 40 MHz. The low pass filter filters this 40 MHz frequency. The filtered signal is a sub-sampled signal representative of the error between the clock 22 and the second oscillator frequency. This signal is phase locked on the reference signal: the phase locking loop is efficient enough to ensure a good accuracy of the error signal provided to the second oscillator.

The effects of this wide band sub sampled phase locking loop is to reduce the power spectral density around the frequency of the second local oscillator, so that this oscillator has the required level of phase noise.

The circuits of figures 2 and 3 thus provide a second oscillator accurately locked to the reference clock, although it does not comprise a resonant cavity. The lower performance of the etched coupled filter lines is compensated by the high performance of the phase locking loop.

Figure 4 is a schematic diagram of an intermediate frequency filter according to the invention; this filter is again a filter without any resonant cavity. The first IF filter uses three resonators etched on a microwave substrate and cascaded as illustrated by figure 4. The cascading of three resonators increased the steepness of the edges of the filter. The number of cascaded resonator may vary according to the needs, as apparent to the person skilled in the art. The structure of each resonator is described below in reference to figure 5. In the schematic view of figure 4, the three resonators are identical; however, as exemplified below, the resonators may be different. In addition, connecting lines of various dimensions may be provided between the resonators.

Figure 5 shows an enlarged view of one of the resonators cascaded in the filter of figure 4. Each resonator is symmetrical in a rotation around one point, and presents two symmetrical paths which are used on one hand to ensure transmission of the signal and on the other hand to obtain the resonant frequency.

More specifically, the resonator of figure 5 is comprised of two halves 30 and 31. These halves are symmetrical around one point A. The overall shape of a resonator is a substantially rectangular, whereby the input 32 of the resonator is located on one corner of the rectangle - in the example the upper left corner - and its output 33 is located on the opposite corner. Two opposite sides of the rectangle are cut at their middle and provide the coupling between the two halves of the resonator. In the example of figure 5, the coupling between the two halves of the resonator occur on the horizontal sides of the rectangle; the upper horizontal side of the rectangle is thus divided into two halves 34 and 35, each of which is provided at its end with a coupling line 40, 41. The coupling lines are separated by a coupling gap. Similarly, the lower horizontal side of the rectangle is divided into two halves 38 and 39; the ends of these halves are provided with a coupling lines 42, 43, between which there is a coupling gap.

The resonator thus provides two symmetrical path; the first path is through the two halves 34 and 35 of the upper and their coupling lines 40, 41 side and through the right vertical side 37; the second path is through the left vertical side 36, the two halves 38 and 39 of the lower side and their coupling lines 42, 43.

To understand the operation of the resonator, one may consider the explanation given with reference to figures 6 and 7. Figure 6 shows the resonator of figure 5 and explains the first path. Figure 7 shows the resonator of figure 5 and explains the second path. On figure 6, the resonator is "opened" by de-coupling the two halves 38, 42 and 39, 43 of the lower side. One may see on figure 6 the current path through the two halves 34 and 35 of the upper side and their coupling lines 40,41 and through the right vertical side 37; one may also see that the left vertical side 36 and one half 38, 42 of the lower side, on one hand and the other half 39, 43 of the lower side on the other hand act as open stubs for matching the resonator at the resonant frequency.

Similarly, on figure 7, the resonator is "opened" by de-coupling the two halves 34 and 35 of the upper side at their coupling lines 40, 41. One may see on figure 7 the current path through the left vertical side 36 and the two halves 38 and 39 of the lower side and their coupling lines 42, 43; one may also see that one half 34 of the upper side with its coupling line 40, on one hand and the other half 35 of the upper side together with its coupling line 41 and the right side 37 on the other hand act as open stubs for matching the resonator at the resonant frequency.

Figures 6 and 7 are "gedanken" experiments for explaining the operation of the resonator of figure 5. They make it clear that the resonator has two paths that at the same time ensure the matching at the appropriate frequency. This topology provides a filter with steep edges in an as small as possible surface with a low cost micro-strip technology.

Each dimension of a resonator is computed to obtain the desired frequency bandwidth, and the desired center frequency for the intermediate filter. In the embodiment of figure 4, the following dimensions may be chosen for the different parts of the resonators described in reference to figure 5. These dimensions are given in mm for a substrate having a thickness of 0,78 mm and an $\varepsilon_r$ of 3,58.

> parts 34, 35, 37, 38 : length 3.43, width 1.72;
> parts 36, 37: length 2.92, width 1.72;
> parts 40, 41, 42, 43: length 4.18, width 1.72;
> coupling gap: 1.07.

The dimensions of the central resonator are the following

> parts 34, 35, 37, 38 : length 2.88, width 2.73;
> parts 36, 37: length 3.48, width 2.73;
> parts 40, 41, 42, 43: length 3.00, width 2.73;
> coupling gap:1.03.

In between each resonator is provided a 1 mm wide line having a length of 5.98 mm. These dimensions provide the following features for the filter:

> central frequency: 4070 MHz;
> insertion loss: 8 dB;
> 3 dB bandwidth: 75 MHz;
> rejection at 3960 and 4180 MHz: 35 dB.

As for the coupled lines filter of figure 2, if a low cost microwave substrate, having large manufacturing tolerance is used, then a tuning of the filter may become necessary. Such tuning may be carried out by applying on the coupling lines of the resonators, a piece of a microwave material of an appropriate size, for instance a piece of substrate glued or screwed at an appropriate position.

Again, as for the coupled lines filter of figure 2, the filter of figure 4 is exemplified in a micro-stripped line embodiment. It could easily be manufactured in a coupled lines or stripped line substrate.

The filter of figures 4 to 7 does not reach the same performance as a dielectric resonator filter, or as a resonant cavity filter; indeed, insertion loss is higher. As an example, the filter used in the embodiment of figure 1 has the following features:

> central frequency: 4070 MHz;
> insertion loss:1,5 dB;

3 dB bandwidth: 15 MHz;

rejection at 3960 and 4180 MHz : 40 dB.

The invention thus proposes to compute the filter so that spurious signals at a frequency corresponding to half the fixed output frequency $f_{out}$ are reduced below the noise floor of the device at the output end of the total filtering. In the exemplified design, the spurious signals at a frequency offset of 110 MHz with respect to the central frequency of the filter are reduced by 35 dB. At this level, the distortion of the following stages of the amplifier does not create spurious before the final resolution bandwidth filters of the spectrum analyser.

When $f_{out}$ is rather low, typically less than 400 MHz, the rejection may be increased by further decoupling the coupling lines 40, 41 and 42, 43 of figure 5, that is by increasing the coupling gap of one or several of the resonators. This increases the insertion loss, which may be compensated by increasing the gain of the first amplifier 4.

In addition, designing of the filter may take into account the following constraints.

As explained above, if some residual signal from the second local oscillator goes up to the first mixer, it may create some spurious signals when mixed with the frequency of the first local oscillator. These spurious signals may prove to be a problem, inasmuch they lie around first intermediate frequency $f_i$, that is around central frequency of filter 3. This is the case where

$$n.f_{ol1} \pm m.f_{ol2} \approx f_i, \text{ with n and m positive integers.}$$

However, intermediate amplifier 4 isolates the first oscillator from the second oscillator, and attenuates signals going from the second mixed to the first mixer. This amplifier is not a penalty for the proposed invention; indeed, it is preferably used in a medium and high performance spectrum analyser to improve sensitivity of the apparatus. In addition, the intermediate amplifier 4 may be manufactured using low cost components found on the market. Since the amplifier should only operate in a low frequency range - of the same magnitude as the bandwidth of the intermediate filter 3 - it may easily be designed with a high isolation and a good noise figure. The amplifier compensates for the losses in the first intermediate filter 3, and in the second mixer, and this further improves sensitivity of the device.

Thus, in a device according to the invention, this type of mixing of signals from both oscillators is not likely to be a problem. Indeed, both local oscillators are isolated one from the other, thanks to the amplifier and filter. This reduces the mixing of frequencies originating from the local oscillators.

As explained above, the frequency $f_{ol2} + f_{out}/2$ coming from or through the first mixer may also create a spurious signal by harmonic mixing in the second mixer. This frequency is thus preferably filtered in the intermediate filter, so as to bring it to the level of the noise floor of the device.

On the other side of the intermediate filter 3 - that is downward of this filter - when searching for a signal at the input frequency $f_{in} = f_{out}/2$, the frequency of the first local oscillator $f_{ol1}$ is equal to $f_i + f_{out}/2$. In this case, the frequencies $f_i$ and $f_{ol1}$ may mix together in the second mixer, and provide a frequency $f_{out}/2$ after the second mixer. If the signal at this frequency is high enough, its second harmonic will create a spurious response at $f_{out}$.

In order to limit the risk of occurrence of such a problem, the second mixer is preferably designed to be as linear as possible to minimise harmonic generation, and the first mixer is preferably designed so as to minimise leakage of the frequency of the first oscillator $f_{ol1}$ from the first oscillator port to the port connected to the amplifier 4. The design of such a mixer is clear for the person skilled in the art. In analysers of the prior art - like the one of figure 1 - the first mixer was also designed to minimise leakage of the of the frequency of the first oscillator; in the device of the invention, it is possible to allow more leakage than it was possible in the prior art device, due to the structure of the device.

This problem only occurs in case of searching for an input frequency at $f_{out}/2$, when the frequency of the first oscillator is $f_i + f_{out}/2$. Rejection of this frequency may also be obtained in the first intermediate filter; the rejection of this frequency in the filter depends upon the maximum input level around $f_{out}/2$.

The same problem applies when the device of the invention is used for searching in a range of frequency around $f_{out}$. In this case, the frequency $f_i + f_{out}$ of the first local oscillator may mix together with the intermediate frequency $f_i$ and create a spurious signal at $f_{out}$. This problem may be dealt with in the same way.

The other mixing products are far from $f_{out}$, and are easy to filter, even without any resonant cavity; otherwise, they result from the mixing of higher harmonics with high conversion loss and low harmonics generation.

Thus, the invention is based on the recognition that the intermediate frequency filter may be a lousy filter with a rather poor quality factor, and a high insertion loss. The invention also relies on the recognition that the insertion loss of the intermediate filter may be compensated by using a low cost and low noise linear amplifier. Manufacturing such an amplifier is possible inasmuch as the frequency range of this amplifier need not be much higher than the bandwidth of the intermediate filter.

Contrary to prior art solutions, where resonant cavities are used for obtaining high quality factors, and for minimising insertion loss, and where the center frequency of the resonant cavity filter is the intermediate frequency because of the low bandwidth, the invention suggest that the center frequency of the intermediate frequency filter need not be tuneable, and may be fixed, while still allowing proper filtering around the intermediate frequency.

The filter exemplified in figures 4 to 7 provides a solution for defining an appropriate filter for a device according to the invention.

The filter of the invention may be used in combination with the oscillator of figures 2 and 3, to provide a frequency converting device without any resonant cavity: all components may be etched from a substrate, or positioned and soldered on the substrate. The design of the oscillator of figure 2 and of the filter of figure 4 permits the etching of the substrate in one etching step only. The etched substrate, with the corresponding components may be mounted in a metallic casing, that ensures the electromagnetic isolation of each part of the device. This casing is preferably spaced constant distance from the substrate, and its size or position is not involved in the processing of the microwave signal. This constant distance may be around 5 mm, this being sufficient for adding on the substrate a frequency tuning element. Thus, the cover of the casing may be formed out of one single plate of metal, and need not comprise, as in the prior art devices, means for changing the sizes or dimensions of cavities.

This device may thus have a smaller form factor, and a lesser weight. The device may be incorporated into the front end of a spectrum analyser, and provides a high range high performance analyser, that remains easy to handle.

The invention is not limited to the embodiments exemplified above. For instance, the filter of figures 4 to 7 may be used independently of the oscillator of figures 2 and 3.

## Claims

1. A frequency converting device, comprising first mixing means (2) for mixing a received signal, in a range of frequencies from several hundreds of hertz to several gigahertz, with the output of first oscillating means (1), amplifying means (4) for amplifying the mixed signal, intermediate frequency filtering means (3) for filtering the amplified signal around an intermediate frequency, and second mixing means (5) for mixing the filtered signal with the output of second oscillating means (6), wherein the filtering means and the second oscillating means are without resonant cavities.

2. A device according to claim 1, wherein the filtering means and the second oscillating means are components formed in a substrate, the major part of the energy propagating through the substrate.

3. A device according to claim 1 or 2, wherein the second oscillating means comprise a feedback oscillator using an etched coupled lines filter (15) as a resonant element.

4. A device according to claim 3, wherein the second oscillating means further comprise a varactor diode (19) for inputting into the second oscillating means the error signal between the second oscillating means and a reference clock.

5. A device according to claim 3 or 4, wherein the second oscillating means are locked to a reference clock (22, 23) by using a wide band phase locking with a sampling system.

6. A device according to one of claims 1 to 5, wherein the intermediate frequency filtering means (3) comprise at least an etched resonator.

7. A device according to claim 6, comprising a plurality of cascaded etched resonators.

8. A device according to claim 6 or 7, wherein a resonator comprises two current paths, each path acting simultaneously as means for matching the resonant frequency of the resonator.

9. A device according to claim 8, wherein each path comprises a coupling gap defined between coupling lines (40, 41, 42, 43).

10. A device according to one of claims 6 to 9, wherein a resonator has the shape of a rectangle cut in the middle of two opposite sides (34, 35 ; 37, 38).

11. A device according to claim 10, wherein the two halves of each opposite side each have at their end a coupling line (40, 41, 42, 43).

12. A device according to claim 10 or 11, wherein the input and output of the resonator are located at opposite corners of the resonator.

13. A device according to one of claims 1 to 12, wherein the first oscillating means have a variable frequency in the range from 3 to 8 GHz.

14. A spectrum analyser with a device according to one of claims 1 to 13.

signal to analyse

Phase locking loop

Phase locking loop

Figure 1

Figure 2

figure 3

Figure 4.

FIGURE 5

FIGURE 6a

FIGURE 6b

**European Patent Office**

## PARTIAL EUROPEAN SEARCH REPORT

which under Rule 45 of the European Patent Convention shall be considered, for the purposes of subsequent proceedings, as the European search report

Application Number

EP 99 40 0535

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | F.LABBROZZI: "DESIGNING FOR SPECTRUM ANALYSIS" ELECTRONICS WORLD AND WIRELESS WORLD, vol. 102, no. 1723, 1 June 1996 (1996-06-01), pages 488-494, XP000597332 ISSN: 0959-8332 * page 491, middle column, paragraph 2; figures 2,6 * * page 488, right-hand column, paragraph 2 * | 1 | G01R23/16 |
| A | KAWABATA S ET AL: "A HIGH-PERFORMANCE 1.8-GHZ VECTOR NETWORK AND SPECTRUM ANALYZER" HEWLETT-PACKARD JOURNAL, vol. 44, no. 5, 1 October 1993 (1993-10-01), pages 76-84, XP000403455 * page 81, right-hand column, last paragraph - page 82, left-hand column, paragraph 3; figure 9 * | 1 | |
| | -/-- | | |

TECHNICAL FIELDS SEARCHED (Int.Cl.7)

G01R
H01P

### INCOMPLETE SEARCH

The Search Division considers that the present application, or one or more of its claims, does/do not comply with the EPC to such an extent that a meaningful search into the state of the art cannot be carried out, or can only be carried out partially, for these claims.

Claims searched completely :

Claims searched incompletely :

Claims not searched :

Reason for the limitation of the search:

see sheet C

| Place of search | Date of completion of the search | Examiner |
|---|---|---|
| BERLIN | 13 August 1999 | Fritz, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C07)

**European Patent Office**

## PARTIAL EUROPEAN SEARCH REPORT

Application Number

EP 99 40 0535

| | DOCUMENTS CONSIDERED TO BE RELEVANT | | CLASSIFICATION OF THE APPLICATION (Int.Cl.7) |
|---|---|---|---|
| Category | Citation of document with indication, where appropriate, of relevant passages | Relevant to claim | |
| A | M.E.EDWARDS ET AL.: "Design of microwave circuits for a spectrum analyser" ELECTRONIC ENGINEERING., vol. 60, no. 734, February 1988 (1988-02), pages 45-50, XP002111985 GB ISSN: 0013-4902 * page 46, middle column, last paragraph - page 48, right-hand column, paragraph 1; figures 2,6 * | 1 | |
| A | DE 195 42 247 A (ADVANTEST CORP) 15 May 1996 (1996-05-15) * abstract; figure 1 * | 1 | |
| A | CUTLER R T ET AL: "RF VECTOR SIGNAL ANALYZER HARDWARE DESIGN" HEWLETT-PACKARD JOURNAL, vol. 44, no. 6, 1 December 1993 (1993-12-01), pages 47-57, 59, XP000422716 * page 50, left-hand column, paragraph 1 - page 51, left-hand column, paragraph 1; figures 1,2 * | 1 | TECHNICAL FIELDS SEARCHED (Int.Cl.7) |
| A | WO 97 47053 A (PHILIPS ELECTRONICS NV ;PHILIPS NORDEN AB (SE)) 11 December 1997 (1997-12-11) * abstract; figure 10 * | 1 | |

EPO FORM 1503 03.82 (P04C10)

European Patent
Office

**INCOMPLETE SEARCH
SHEET C**

Application Number

EP 99 40 0535

Claim(s) searched incompletely:
    1 to 14

Reason for the limitation of the search:

Present claims 1 to 14 relate to a frequency converting device defined in a negative manner by reference to a desirable characteristic or property, namely that the filtering means and the second oscillating means are without resonant cavities.
The claims cover all frequency converting devices having this characteristic or property, whereas the application provides support within the meaning of Article 84 EPC and disclosure within the meaning of Article 83 EPC for only a very limited number of such frequency converting devices. In the present case, the claims so lack support, and the application so lacks disclosure, that a meaningful search over the whole of the claimed scope is impossible. Independent of the above reasoning, the claims also lack clarity (Article 84 EPC). An attempt is made to define the frequency converting device by reference to a result to be achieved. Again, this lack of clarity in the present case is such as to render a meaningful search over the whole of the claimed scope impossible. Consequently, the search has been carried out for those parts of the claims which appear to be clear, supported and disclosed, namely those parts relating to the frequency converting device according to claim 1 wherein the filtering means and the second oscillating means are devices in which the energy is mainly propagated in a substrate, wherein the phase noise degradation of the second oscillating means is reduced near the carrier by using a wide band sub-sampled phase locking loop, and wherein the performance degradation of the filtering means is reduced by using a plurality of cascaded etched resonators and an adapted amplifying means, see page 7, lines 3 to 11, page 8, lines 1 to 8 and 32 to 34; page 11, lines 6 to 19; and page 13, lines 1 to 6.

EP 1 037 059 A1

## ANNEX TO THE EUROPEAN SEARCH REPORT
## ON EUROPEAN PATENT APPLICATION NO.

EP 99 40 0535

This annex lists the patent family members relating to the patent documents cited in the above-mentioned European search report.
The members are as contained in the European Patent Office EDP file on
The European Patent Office is in no way liable for these particulars which are merely given for the purpose of information.

13-08-1999

| Patent document cited in search report | | Publication date | Patent family member(s) | | Publication date |
|---|---|---|---|---|---|
| DE 19542247 | A | 15-05-1996 | JP | 8233875 A | 13-09-1996 |
| | | | US | 5736845 A | 07-04-1998 |
| WO 9747053 | A | 11-12-1997 | CN | 1198258 A | 04-11-1998 |
| | | | EP | 0843903 A | 27-05-1998 |
| | | | US | 5880652 A | 09-03-1999 |

EPO FORM P0459

For more details about this annex : see Official Journal of the European Patent Office, No. 12/82